# DEMANDE DE BREVET EUROPEEN

(11) **EP 3 168 057 A1**
(43) Date de publication de la demande: **17.05.2017**
(21) Numéro de dépôt: 15194158.0
(22) Date de dépôt: 11.11.2015
(51) Int. Cl.: B44F 7/00, C25D 1/00, G04B 45/00

(54) **PROCEDE DE FABRICATION D'UNE PIECE METALLIQUE AVEC AU MOINS UN MOTIF A ILLUSION D'OPTIQUE**

(71) Demandeur: Nivarox-FAR S.A., 2400 Le Locle (CH)
(72) Inventeur: Cusin, Pierre, 1423 Villars-Burquin (CH); Gandelhman, Alex, 2000 Neuchâtel (CH)
(74) Mandataire: Goulette, Ludivine

(57) **Abrégé**

L'invention se rapporte à un procédé de fabrication d'une pièce monobloc de forme simple à base de métal offrant l'illusion d'un facettage et/ou d'un chanfreinage pour former tout ou partie de l'habillage d'une pièce d'horlogerie.

## Description

### Domaine de l'invention

L'invention se rapporte à un procédé de fabrication d'une pièce à base de métal comportant au moins un motif à illusion d'optique et, plus précisément, au moins un motif faisant croire que la surface supérieure n'est pas plane.

### Arrière-plan de l'invention

Il est connu de former des pièces d'habillage dont la surface supérieure est facettée et/ou chanfreinée afin d'améliorer l'esthétique d'une pièce d'horlogerie. Le document EP 1 557 729 divulgue notamment la très grande difficulté à développer un procédé de fabrication de pièces facettées ne nécessitant pas d'étape de retouche.

### Résumé de l'invention

Le but de la présente invention est de pallier tout ou partie les inconvénients cités précédemment en proposant un procédé de fabrication ne nécessitant ni facettage ni retouche pour obtenir une pièce simple à base de métal offrant l'illusion d'un facettage et/ou d'un chanfreinage.

A cet effet, l'invention se rapporte à un procédé de fabrication d'une pièce à base de métal avec au moins un motif à illusion d'optique caractérisé en ce qu'il comporte les étapes suivantes :
a) former un substrat dont la surface supérieure plane est électriquement conductrice et comporte des nervures négatives dudit au moins un motif à illusion d'optique de ladite pièce à fabriquer ;
b) former un moule sur le substrat, le moule comportant des cavités dont le fond est formé par ladite face supérieure du substrat ;
c) remplir les cavités du moule par galvanoplastie pour former ladite pièce à base de métal avec au moins un motif à illusion d'optique ;
d) libérer la pièce ainsi formée du substrat et du moule.

On comprend donc que le procédé de fabrication permet, grâce à la planéité du substrat, d'obtenir une pièce dont la surface supérieure plane n'a pas besoin d'être facettée ou, plus globalement, retouchée.

De plus, le procédé de fabrication offre une très grande précision des cotes et très grande reproductibilité d'une même pièce monobloc à base de métal ou de plusieurs pièces monoblocs différentes à base de métal sur un même substrat.

Enfin, la très grande précision et la très grande reproductibilité du procédé de fabrication permet, avantageusement selon l'invention, d'obtenir une pièce très simple munie d'au moins un motif très fin et facilement reproductible faisant croire que la surface supérieure n'est pas plane à la manière d'un usinage comme un biseautage ou un chanfreinage.

Conformément à d'autres variantes avantageuses de l'invention :
- selon un premier mode de réalisation, les nervures forment au moins deux séries de segments parallèles, la première série de segments parallèles joignant la deuxième série de segments parallèles selon un angle compris entre 10 et 170 degrés afin d'offrir à ladite pièce l'illusion d'une face supérieure avec deux faces biseautées formant une arête ;
- selon un deuxième mode de réalisation, les nervures forment au moins une série de segments courbes afin d'offrir à ladite pièce l'illusion d'une face supérieure bombée ;
- selon un troisième mode de réalisation, les nervures forment au moins une série d'évidements distribués symétriquement les uns par rapport aux autres, ladite au moins une série d'évidements étant formée adjacente à une partie dont la surface supérieure du substrat ne comporte aucune nervure négative afin d'offrir à ladite pièce l'illusion d'une face supérieure avec deux faces biseautée formant une arête ;

- selon un quatrième mode de réalisation, les nervures sont distribuées à la périphérie des cavités du moule et forment au moins deux séries de segments parallèles, les segments parallèles de la première série étant perpendiculaires aux segments parallèles de la deuxième série et se joignant selon un angle à 90 degrés afin d'offrir à ladite pièce l'illusion d'une face supérieure chanfreinée ;
- quel que soit le mode de réalisation, les nervures ont une hauteur comprise entre 2 et 100 micromètres ;
- le procédé comporte en outre, entre l'étape c) et l'étape d), l'étape e) : usiner sélectivement une partie de la pièce à base de métal afin de former une pièce avec un moyen de fixation ;
- la surface supérieure du substrat est rendue électriquement conductrice par le dopage d'un substrat en silicium et/ou par le dépôt d'une couche électriquement conductrice sur un substrat en silicium ;
- le substrat comporte une épaisseur comprise entre 0,3 et 1 mm ;
- l'étape b) comporte les phases f) : déposer une couche de résine photosensible sur la surface supérieure électriquement conductrice du substrat, g) : illuminer sélectivement une partie de la résine photosensible et h) : développer la résine photosensible afin de former les cavités du moule ;
- la pièce est formée à base de nickel ou de nickel-phosphore ;
- plusieurs pièces sont formées sur le même substrat ;
- la pièce forme tout ou partie d'un cadran, d'une décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

L'invention se rapporte également à l'habillage d'une pièce d'horlogerie comportant une pièce à base de métal obtenue à partir du procédé selon l'une des variantes précédentes, caractérisé en ce que la pièce comporte une surface supérieure sensiblement plane avec au moins un motif à illusion d'optique faisant croire que la surface supérieure n'est pas plane.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations schématiques d'étapes d'un procédé selon l'invention ;
- les figures 6 à 9 représentent des exemples d'aiguilles obtenues selon l'invention ;
- les figures 10 à 15 représentent des exemples d'heures index obtenus selon l'invention ;
- la figure 16 représente un exemple de décoration de guichet obtenu selon l'invention.

### Description détaillée des modes de réalisation préférés

La présente invention se rapporte à un procédé de fabrication d'une pièce monobloc de forme simple à base de métal offrant l'illusion d'un facettage et/ou d'un chanfreinage pour former tout ou partie de l'habillage d'une pièce d'horlogerie. A titre d'exemple nullement limitatif, la pièce peut ainsi former tout ou partie d'un cadran, d'une décoration de guichet, d'un réhaut, d'une lunette, d'un poussoir, d'une couronne, d'un fond de boîtier, d'une masse oscillante, d'une aiguille, d'un bracelet, d'un maillon, d'un fermoir, d'un décor ou d'une applique.

Bien entendu, une telle pièce ne saurait se limiter au domaine de l'horlogerie. A titre d'exemple nullement limitatif, une telle pièce pourrait alternativement former tout ou partie d'un article de bijouterie ou de joaillerie.

Le procédé est destiné à fabriquer une pièce à base de métal. Le terme « à base de métal » signifie qu'un ou plusieurs métaux peuvent entrer dans la composition de la pièce. Ainsi, à titre d'exemple nullement limitatif, la pièce peut par exemple être formée à base de nickel ou de nickel-phosphore.

Avantageusement selon l'invention, la pièce à base de métal obtenue par le procédé comporte au moins un motif à illusion d'optique. Plus précisément, la pièce comporte, de manière avantageuse, une surface supérieure sensiblement plane avec au moins un motif à illusion d'optique faisant croire que la surface supérieure n'est pas plane ce qui permet d'avoir une pièce simple offrant, par exemple, l'illusion d'un facettage et/ou d'un chanfreinage.

Par soucis de simplification, les figures présentées montrent la fabrication d'une seule pièce sur un substrat. Toutefois, avantageusement selon l'invention, le procédé autorise plusieurs pièces identiques ou différentes à être formées sur le même substrat.

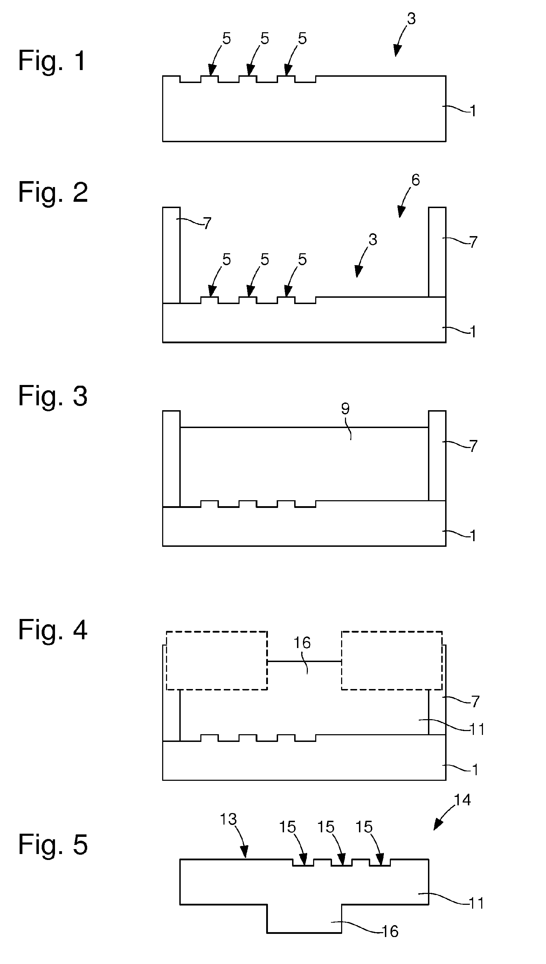

Comme visible à la figure 1, le procédé selon l'invention comporte une première étape a) destinée à former un substrat 1 dont la surface supérieure 3 plane est électriquement conductrice et comporte des nervures 5 négatives dudit au moins un motif à illusion d'optique de la pièce à fabriquer. La forme générale dudit au moins un motif à illusion d'optique sera mieux expliquée ci-dessous. Pour des raisons d'intelligibilité, les nervures 5 sont représentées schématiquement par trois plots en saillie de la surface supérieure 3 du substrat 1 à la figure 1.

Une grande variété de substrats 1 est possible. Préférentiellement, la matière du substrat 1 est choisie pour sa facilité à être rendue plane et sa très faible rugosité, c'est-à-dire son caractère naturel à présenter une surface lisse. A titre d'exemple, un substrat 1 à base de silicium possède ces deux avantages.

Dans le cas où le substrat 1 est en silicium, l'étape a) peut alors comporter une première phase destinée à revêtir le substrat 1 d'un masque présentant des ajourages laissant non recouverte une partie supérieure du substrat 1. Dans une deuxième phase, un gravage selon les ajourages du masque pourrait être effectué. Un tel gravage peut être réalisé par une attaque sèche ou humide. Enfin, dans une troisième phase illustrée à la figure 1, le masque 2 est retiré pour ne laisser que les nervures 5 réalisées sur la surface supérieure 3 du substrat 1.

Dans le cas où le substrat 1 est en silicium, la surface supérieure 3 du substrat 1 peut être rendue électriquement conductrice par le dopage du silicium, c'est-à-dire en utilisant un substrat 1 déjà dopé avant son gravage, et/ou par le dépôt d'une couche électriquement conductrice.

De plus, le substrat 1 peut comporter une épaisseur comprise entre 0,3 et 1 mm alors que les nervures 5 peuvent s'étendre selon une hauteur comprise entre 2 et 100 micromètres à partir de la surface supérieure 3 du substrat 1.

Comme illustré à la figure 2, le procédé se poursuit avec une deuxième étape b) destinée à former un moule 7 sur le substrat 1. On comprend donc que le moule 7 comportant des cavités 6 dont le fond est formé par la face supérieure 3 du substrat 1.

L'étape b) comporte préférentiellement les trois phases f) à h). L'étape b) comporte une première phase f) destinée à déposer une couche de résine photosensible sur la surface supérieure 3 électriquement conductrice du substrat 1. Une telle phase f) peut être obtenue par enduction centrifuge (également connue sous les termes anglais « spin coating ») ou par pulvérisation (également connue sous les termes anglais « spray coating »). La deuxième phase g) est destinée à illuminer sélectivement une partie de la résine photosensible. On comprend donc que suivant la nature de la résine photosensible, c'est-à-dire si la résine est du type positif ou négatif, l'illumination sera focalisée sur les futures cavités 6 souhaitées ou sur les parties autres que les futures cavités 6 souhaitées.

Enfin, l'étape b) se termine avec une troisième phase h) destinée à développer la résine photosensible sélectivement illuminée afin de former le moule 7, c'est-à-dire durcir la résine photosensible restant entre les cavités 6. Cette troisième phase h) est généralement obtenue par un traitement thermique destiné à durcir la résine suivi d'un développement destiné à former les cavités 6.

Comme illustré à la figure 3, le procédé continue avec une troisième étape c) destinée à remplir les cavités 6 du moule 7 par galvanoplastie pour former l'ébauche ou la pièce à base de métal avec au moins un motif 14 à illusion d'optique. Selon l'invention, la pièce à base de métal possède un même motif en projection. Toutefois, par la structuration du substrat 1, les nervures 5 vont former lors de l'étape c), des évidements 15 sur la surface externe de l'ébauche ou de la pièce à base de métal. En effet, comme cela est expliqué ci-dessous, une étape optionnelle e) peut être mise en oeuvre après l'étape c).

Avantageusement selon l'invention, le procédé permet, grâce à l'étape b) très précise de photolithographie, d'obtenir un bloc 9 à base de métal avec des cotes externes et, éventuellement, internes d'une grande précision propre à respecter les tolérances très élevées d'une pièce dans le domaine de l'horlogerie. Par cotes internes, il faut comprendre, qu'à partir d'éventuelles parties de résine 7 structurée qui sont enclavée dans des cavités 6, des ajourages et/ou des trous dans la pièce métallique peuvent être directement formés lors de l'étape c).

Comme expliqué ci-dessus, le remplissage galvanique des cavités 6 lors de l'étape c) peut, par exemple, être effectué avec un alliage formé de nickel et de phosphore (NiP) et notamment un tel alliage dont la proportion de phosphore est sensiblement égale à 12% (NiP12).

Enfin, le procédé se termine avec une quatrième et dernière étape d) destinée à libérer la pièce ainsi formée du substrat 1 et du moule 7. Par conséquent, dans l'exemple ci-dessus dans lequel le substrat 1 est en silicium, l'étape d) peut consister en une attaque sélective du silicium et une attaque sélective du matériau du moule 7. L'attaque du silicium peut, par exemple, être obtenu par une attaque chimique au moyen d'un bain comportant de l'hydroxyde de potassium (connu sous l'abréviation KOH).

Selon une variante de l'invention illustrée aux figures 4 et 5, le procédé comporte en outre, entre l'étape c) et l'étape d), l'étape optionnelle e) destinée à usiner sélectivement une partie de la pièce à base de métal afin de former une pièce 11 avec au moins un moyen 16 de fixation.

Comme expliqué ci-dessus, le bloc 9 possédant un même motif en projection est alors modifié dans son épaisseur afin de former au moins un moyen 16 de fixation. On obtient ainsi la pièce 11 sans avoir à former plusieurs niveaux fonctionnels empilés ni toucher à la surface de la pièce comportant ledit au moins un motif 14 à illusion d'optique.

Du fait du positionnement précis de chaque bloc 9 sur le substrat 1, il est possible, lors de l'étape e), d'usiner chaque bloc 9 encore sur le substrat 1 avec un automate programmable selon des cotes précises. On remarque que, même si l'étape e) est destinée à usiner chaque bloc 9, une partie de la résine 7 peut éventuellement être également usinée par les contraintes dues à l'encombrement des outils utilisés ou les volumes à enlever comme illustré par les dégagements visibles à la figure 4. Bien entendu, cette étape e) peut également permettre de mettre à niveau, par rodage, le moule 7 et le bloc 9.

On comprend alors, qu'en plus de la surface supérieure 13 plane et des évidements 15 formant ledit au moins un motif 14 à illusion d'optique, la pièce 11 comporte en outre au moins un moyen 16 de fixation destiné à attacher la pièce. Le moyen 16 de fixation peut ainsi prendre la forme d'un pied ou d'un canon.

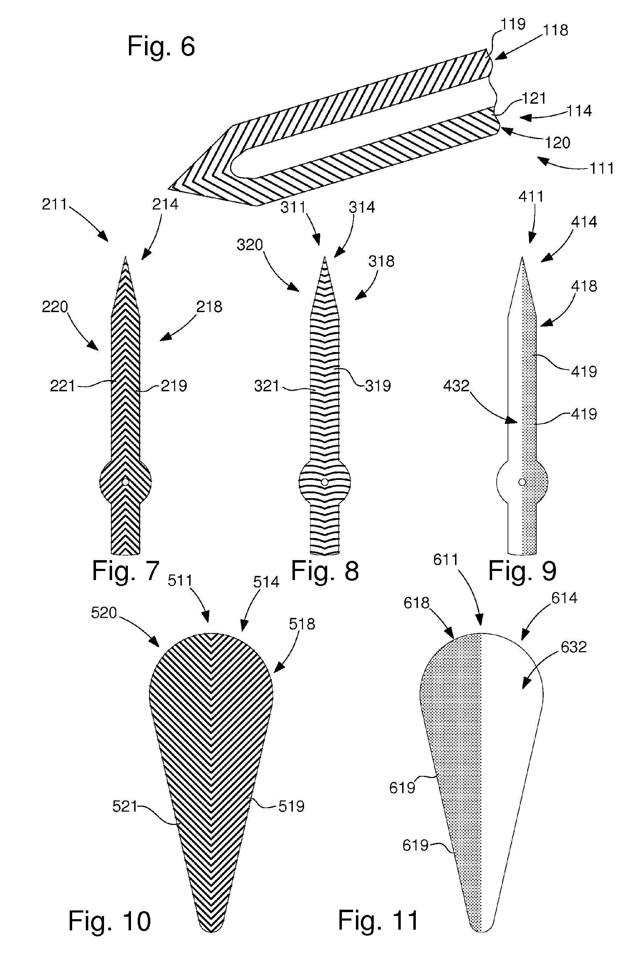

Les figures 6 à 16 représentent des exemples de pièces obtenues selon le procédé permettant de mieux expliquer un motif à illusion d'optique selon l'invention. A titre nullement limitatif, il est expliqué quatre modes de réalisation de motif à illusion d'optique.

Selon un premier mode de réalisation, le substrat 1 comporte des nervures permettant d'obtenir les exemples des figures 6, 7, 10 et 12. Le motif 114, 214, 514 et 714 à illusion d'optique des figures 6, 7, 10 et 12 forment ainsi au moins deux séries 118, 120, 218, 220, 518, 520, 718, 720 de segments 119, 121, 219, 221, 519, 521, 719, 721 parallèles. Préférentiellement selon le premier mode de réalisation, la première série 118, 218, 518, 718 de segments 119, 219, 519, 719 parallèles joignant la deuxième série 120, 220, 520, 720 de segments 121, 221, 521, 721 parallèles selon un angle compris entre 10 et 170 degrés afin d'offrir à la pièce 111, 211, 511, 711 l'illusion d'une face supérieure avec deux faces biseautées formant une arête alors qu'elle est plane.

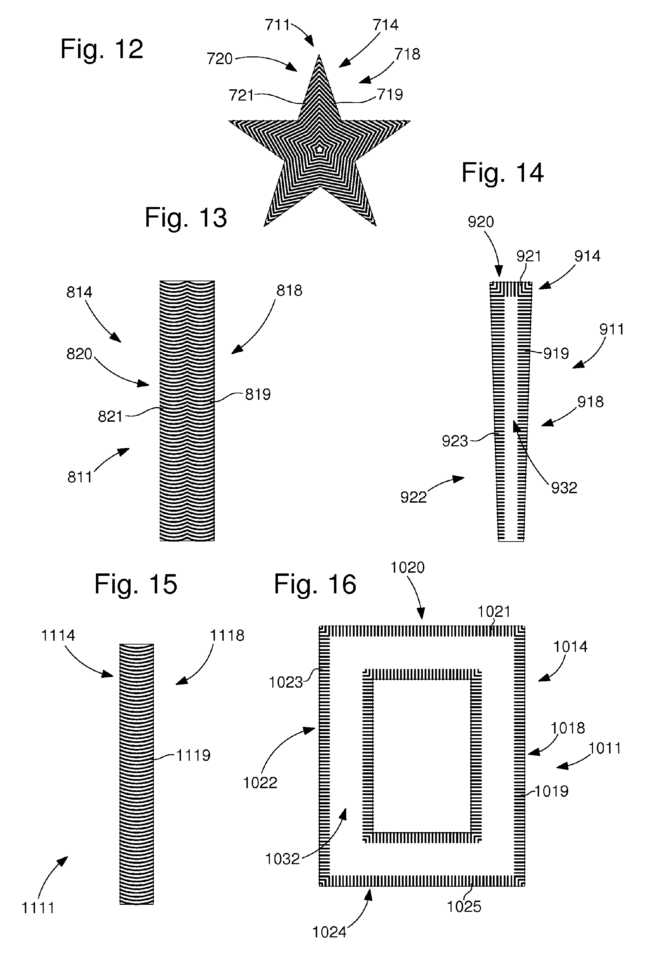

Selon un deuxième mode de réalisation, le substrat 1 comporte des nervures permettant d'obtenir les exemples des figures 8, 13 et 15. Le motif 314, 814 et 1114 à illusion d'optique des figures 8, 13 et 15 forment ainsi au moins une séries 318, 320, 818, 820, 1118 de segments 319, 321, 819, 821, 1119 courbes afin d'offrir à ladite pièce l'illusion d'une face supérieure bombée alors qu'elle est plane. Selon une variante du deuxième mode de réalisation visible aux figures 8 et 13, une première série 318, 818 de segments 319, 819 courbes joint une deuxième série 320, 820 de segments 321, 821 courbes selon un angle compris entre 10 et 170 degrés afin d'offrir à ladite pièce l'illusion d'une face supérieure avec deux faces bombées se rejoignant en formant une rainure alors que la face supérieure est plane.

Selon un troisième mode de réalisation, le substrat 1 comporte des nervures en forme de plots permettant d'obtenir les exemples des figures 9 et 11. Le motif 414 et 614 à illusion d'optique des figures 9 et 11 forment ainsi au moins une série 418, 618 d'évidements 419, 619 distribués symétriquement les uns par rapport aux autres. Préférentiellement selon le troisième mode de réalisation, ladite au moins une série 418, 618 d'évidements étant formée adjacente à une partie 432, 632 dont la surface de la pièce 411, 611 ne comporte aucun motif à illusion d'optique afin d'offrir à ladite pièce l'illusion d'une face supérieure avec deux faces biseautée formant une arête alors qu'elle est plane.

Comme visible aux figures 9 et 11, les évidements 419, 619 sont de section circulaire et régulièrement espacés entre eux. Bien entendu, la géométrie et la distribution des évidements 419, 619 peuvent différer suivant l'effet souhaité sans sortir du cadre de l'invention.

Selon un quatrième mode de réalisation, le substrat 1 comporte des nervures qui sont distribuées à la périphérie des cavités du moule permettant d'obtenir les exemples des figures 14 et 16. Le motif 914 et 1014 à illusion d'optique des figures 14 et 16 forment ainsi au moins deux séries 918, 920, 922, 1018, 1020, 1022, 1024 de segments 919, 921, 923, 1019, 1021, 1023, 1025 parallèles, les segments 919, 923, 1019, 1023 parallèles de la première série 918, 922, 1018, 1022 étant perpendiculaires aux segments 921, 1021, 1025 parallèles de la deuxième série 920, 1020, 1024 et se joignant selon un angle à 90 degrés afin d'offrir à la pièce l'illusion d'une face supérieure chanfreinée entourant une partie 932, 1032 dont la surface de la pièce 911, 1011 ne comporte aucun motif à illusion d'optique.

Bien entendu, la présente invention ne se limite pas à l'exemple illustré mais est susceptible de diverses variantes et modifications qui apparaîtront à l'homme de l'art. En particulier, les pièces 11, 111, 211, 311, 411, 11, 611, 11, 811, 11, 101 pourrait faire l'objet d'une étape finale de durcissement comme par exemple divulgué dans le document EP 15 184 492 incorporé par référence à la présente demande.

Il est également envisageable que les nervures 5 puissent alternativement être formées par une photolithographie d'une résine photosensible sur la surface supérieure plane d'un substrat.

Dans une alternative particulière, le substrat 1 pourrait également être choisi afin de former des nervures 5 de géométrie différente de celle présentée aux figures 1 à 4. Ainsi, à titre d'exemple nullement limitatif, le substrat 1 pourrait être en silicium monocristallin orienté selon le plan (100) et subir un gravage humide à l'hydroxyde de potassium (KOH) permettant de former des gravures dont les flancs sont obliques et non verticaux comme illustré aux figures 1 à 4.

Enfin, les motifs à illusion d'optique ne sauraient se limiter à ceux décrits ci-dessus. Ainsi, d'autres modes de réalisation sont possibles sans sortir du cadre de l'invention. De plus, les quatre modes de réalisation présentés ci-dessus sont susceptibles d'être combinés entre eux, c'est-à-dire que plusieurs motifs différents peuvent apparaître sur la même pièce.

## Revendications

1. Procédé de fabrication d'une pièce (11, 111, 211, 311, 411, 511, 611, 711, 811, 911, 1011, 1111) à base de métal avec au moins un motif (14, 114, 214, 314, 414, 514, 614, 714, 814, 914, 1014, 1114) à illusion d'optique **caractérisé en ce qu'**il comporte les étapes suivantes :
a) former un substrat (1) dont la surface (3) supérieure plane est électriquement conductrice et comporte des nervures (5) négatives dudit au moins un motif à illusion d'optique de ladite pièce à fabriquer ;
b) former un moule (7) sur le substrat (1), le moule (7) comportant des cavités (6) dont le fond est formé par ladite face supérieure du substrat (1) ;
c) remplir les cavités (6) du moule par galvanoplastie pour former ladite pièce à base de métal avec au moins un motif à illusion d'optique ;
d) libérer la pièce (11, 111, 211, 311, 411, 511, 611, 711, 811, 911, 1011, 1111) ainsi formée du substrat (1) et du moule (7).

2. Procédé selon la revendication précédente, **caractérisé en ce que** les nervures (5) forment au moins deux séries de segments parallèles, la première série de segments parallèles joignant la deuxième série de segments parallèles selon un angle compris entre 10 et 170 degrés afin d'offrir à ladite pièce l'illusion d'une face supérieure avec deux faces biseautées formant une arête.

3. Procédé selon la revendication 1, **caractérisé en ce que** les nervures (5) forment au moins une série de segments courbes afin d'offrir à ladite pièce l'illusion d'une face supérieure bombée.

4. Procédé selon la revendication 1, **caractérisé en ce que** les nervures (5) forment au moins une série d'évidements distribués symétriquement les uns par rapport aux autres, ladite au moins une série d'évidements étant formée adjacente à une partie dont la surface supérieure du substrat ne comporte aucune nervure négative afin d'offrir à ladite pièce l'illusion d'une face supérieure avec deux faces biseautée formant une arête.

5. Procédé selon la revendication 1, **caractérisé en ce que** les nervures (5) sont distribuées à la périphérie des cavités du moule et forment au moins deux séries de segments parallèles, les segments parallèles de la première série étant perpendiculaires aux segments parallèles de la deuxième série et se joignant selon un angle à 90 degrés afin d'offrir à ladite pièce l'illusion d'une face supérieure chanfreinée.

6. Procédé selon l'une des revendications précédentes, **caractérisé en ce que** les nervures (5) ont une hauteur comprise entre 2 et 100 micromètres.

7. Procédé selon l'une des revendications précédentes, **caractérisé en ce que** le procédé comporte en outre, entre l'étape c) et l'étape d), l'étape suivante :
e) usiner sélectivement une partie de la pièce (11, 111, 211, 311, 411, 511, 61 1, 711, 811, 911, 1011, 1111) à base de métal afin de former une pièce (11, 111, 211, 311, 411, 511, 611, 711, 811, 911, 1011, 1111) avec un moyen (16) de fixation.

8. Procédé selon l'une des revendications précédentes, **caractérisé en ce que** la surface (3) supérieure du substrat est rendue électriquement conductrice par le dopage d'un substrat en silicium et/ou par le dépôt d'une couche électriquement conductrice sur un substrat en silicium.

9. Procédé selon l'une des revendications précédentes, **caractérisé en ce que** le substrat (1) comporte une épaisseur comprise entre 0,3 et 1 mm.

10. Procédé (1) selon l'une des revendications précédentes, **caractérisé en ce que** l'étape b) comporte les phases suivantes :
f) déposer une couche de résine photosensible sur la surface supérieure électriquement conductrice du substrat ;
g) illuminer sélectivement une partie de la résine photosensible ;
h) développer la résine photosensible afin de former les cavités du moule.

11. Procédé selon l'une des revendications précédentes, **caractérisé en ce que** la pièce (11, 111, 211, 311, 411, 511, 611, 711, 811, 911, 1011, 1111) est formée à base de nickel ou de nickel-phosphore.

12. Procédé selon l'une des revendications précédentes, **caractérisé en ce que** plusieurs pièces sont formées sur le même substrat.

13. Procédé selon l'une des revendications précédentes, **caractérisé en ce que** la pièce (11, 111, 211, 311, 411, 511, 611, 711, 811, 911, 1011, 1111) forme tout ou partie d'un cadran, d'une décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

14. Habillage d'une pièce d'horlogerie comportant une pièce (11, 111, 211, 311, 411, 511, 611, 711, 811, 911, 1011, 1111) à base de métal obtenue à partir du procédé selon l'une des revendications précédentes, **caractérisé en ce que** la pièce (11, 111, 211, 311, 411, 511, 611, 711, 811, 911, 1011, 1111) comporte une surface (13) supérieure sensiblement plane avec au moins un motif (14, 114, 214, 314, 414, 514, 614, 714, 814, 914, 1014, 1114) à illusion d'optique faisant croire que la surface (13)supérieure n'est pas plane.
